(19) **Europäisches Patentamt**
**European Patent Office**
**Office européen des brevets**

(11) **EP 3 984 939 B1**

(12) **EUROPEAN PATENT SPECIFICATION**

(45) Date of publication and mention
of the grant of the patent:
**23.08.2023 Bulletin 2023/34**

(21) Application number: **20201838.8**

(22) Date of filing: **14.10.2020**

(51) International Patent Classification (IPC):
***B66B 5/00*** *(2006.01)*

(52) Cooperative Patent Classification (CPC):
**B66B 5/0018;** Y02B 50/00

(54) **POWER CONSUMPTION CALCULATION**

LEISTUNGSVERBRAUCHBERECHNUNG

CALCUL DE CONSOMMATION D'ÉNERGIE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**20.04.2022 Bulletin 2022/16**

(73) Proprietor: **KONE Corporation**
**00330 Helsinki (FI)**

(72) Inventors:
• **Perunka, Pekka**
**00330 Helsinki (FI)**
• **Perälä, Pekka**
**00330 Helsinki (FI)**
• **Raitola, Pasi**
**00330 Helsinki (FI)**

• **Ruokokoski, Mirko**
**00330 Helsinki (FI)**
• **Tukia, Toni**
**00330 Helsinki (FI)**
• **Krantz, Mikael**
**00330 Helsinki (FI)**
• **Tyni, Tapio**
**00330 Helsinki (FI)**

(74) Representative: **Kolster Oy Ab**
**Salmisaarenaukio 1**
**P.O. Box 204**
**00181 Helsinki (FI)**

(56) References cited:
**JP-A- 2013 052 943     US-B1- 6 857 506**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

FIELD

The present invention relates to power consumption of an elevator or an escalator or a moving walkway.

BACKGROUND

The evolvement of networking between computers and measurement devices, especially different sensors, capable of communicating without user involvement, has enabled remote monitoring and remote metering, for example. A trend in remote metering is to measure individual sources. For example, in buildings power meters are installed to individual power consuming sources to measure their power consumption, thereby paving the way towards smart buildings. Elevators, escalators and moving walkways also play their part in the power consumption. However, power meters are rarely installed to them. JP 2013052943 discloses solutions how to integrate energy consumption using values obtained by calculating electric energy consumed by a hoisting motor of an elevator based on operation status information, using values in current consumption tables. A current consumption can be obtained from a current consumption table based on a rated speed and a load factor. A power consumption may be calculated from the current consumption.

BRIEF DESCRIPTION

The scope of the invention is defined in the independent claims. Some embodiments are defined in the dependent claims.

According to an aspect there is provided a remote monitoring equipment for an apparatus, which is an elevator or an escalator or a moving walkway, the equipment comprising: a data storage comprising apparatus-specific static power consumption models, a static power consumption model modelling power consumption and being parametrized with apparatus-specific parameters; means for receiving controller events relating to the apparatus; means for determining from the controller events a distance to travel, a time and a load; means for calculating, using an apparatus-specific static power consumption model of the apparatus and the distance to travel, the time and the load, a total power consumed by the apparatus; and means for outputting the total power.

In an embodiment, the means for calculating are configured to calculate predictions of the total power and the means for outputting are configured to output the predictions of the total power.

In an embodiment, the equipment further comprises means for calculating energy consumption of the apparatus by integrating the total power over a time the energy consumption is to be determined and/or means for calculating a predicted energy consumption of the apparatus by integrating the predictions of the total power over a time for which the predictions are available.

In an embodiment, the equipment further comprises means for sending the total power and/or the predictions of the total power and/or the energy consumption and/or the predicted energy consumption to a building management system.

In an embodiment, the equipment further comprises means for detecting a peak or drop in the predictions and means for sending information on the peak or drop to a building management system for mitigating the change in the power consumption.

In an embodiment, the equipment further comprises means for storing to the data storage received controller events with time information.

In an embodiment, at least one of the apparatus-specific static power consumption models is a precalculated three dimensional matrix, the dimensions being a distance to travel, a load and a time.

In an embodiment, the apparatus -specific parameters include one or more of parameters from a group of parameters comprising a speed, an acceleration, a jerk, a travel distance between floors, a maximum travel distance, a nominal load, a roping, a rope type, a cable type, a motor resistance, a motor type, drive efficiency, and a drive type.

In an embodiment, the equipment further comprises at least one processor; and at least one memory including computer program code; the at least one memory and the computer program code being configured to, with the at least one processor, provide the means.

According to another aspect there is provided a computer implemented method comprising: receiving controller events relating to an apparatus, which is an elevator or an escalator or a moving walkway; determining from the controller events a distance to travel, a time and a load; calculating, using an apparatus-specific static power consumption model of the apparatus, which models power consumption and has been parametrized with apparatus-specific parameters, and the distance to travel, the time and the load, a total power consumed by the apparatus; and outputting the total power.

In an embodiment, the method further comprises: calculating, using the apparatus-specific static power consumption model the distance to travel, the time and the load, predictions of the total power; and outputting the predictions of the total power.

In an embodiment, the method further comprises: calculating energy consumption by integrating the total power over a time the energy consumption is to be determined; and causing sending the energy consumption to a building management system.

In an embodiment, the method further comprises: calculating a predicted energy consumption of the apparatus by integrating the predictions of the total power over a time for which the predictions are available; and
causing sending the energy consumption to the building management system.

In an embodiment, the method further comprises: detecting a peak or drop in the predictions; and causing sending information on the peak or drop to a building management system for mitigating the change in the power consumption.

In an embodiment, the method further comprises storing received controller events with time information.

According to a further aspect there is provided a computer program product according to claim 16.

According to another aspect there is provided a computer-readable storage medium according to claim 17.

One or more examples of implementations are set forth in more detail in the accompanying drawings and the description below. Other features will be apparent from the description and drawings, and from the claims.

BRIEF DESCRIPTION OF DRAWINGS

In the following, example embodiments will be described in greater detail with reference to the attached drawings, in which

    Figure 1 illustrate exemplified remote monitoring system;
    Figure 2 illustrates an exemplified static power consumption model;
    Figures 3 to 6 illustrate different example functionalities; and
    Figure 7 is a schematic block diagram.

DETAILED DESCRIPTION OF SOME EMBODIMENTS

The following embodiments are only presented as examples. Although the specification may refer to "an", "one", or "some" embodiment(s) and/or example(s) in several locations of the text, this does not necessarily mean that each reference is made to the same embodiment(s) or example(s), or that a particular feature only applies to a single embodiment and/or example. Single features of different embodiments and/or examples may also be combined to provide other embodiments and/or examples. Manners of device management and remote metering develop constantly and hence the used terms should be understood as not limiting. Further, although terms including ordinal numbers or alphabets, such as "first", "second", "A", "B", etc., may be used for describing various elements, the elements are not restricted by the terms. The terms are used merely for the purpose of distinguishing an element from other elements. For example, a first element could be termed a second element, and similarly, a second element could be also termed a first element without departing from the scope of the present invention. Consequently, all terms and expressions should be interpreted broadly, and they are intended to describe, not to restrict, the invention.

In the examples described below elevator is used as an example of any apparatus that is or has a frame fixedly mounted to a building and that may transport people and/or goods between two points in the building, and the examples cover any such apparatus. Examples of such apparatuses include an elevator, an escalator and a moving walkway.

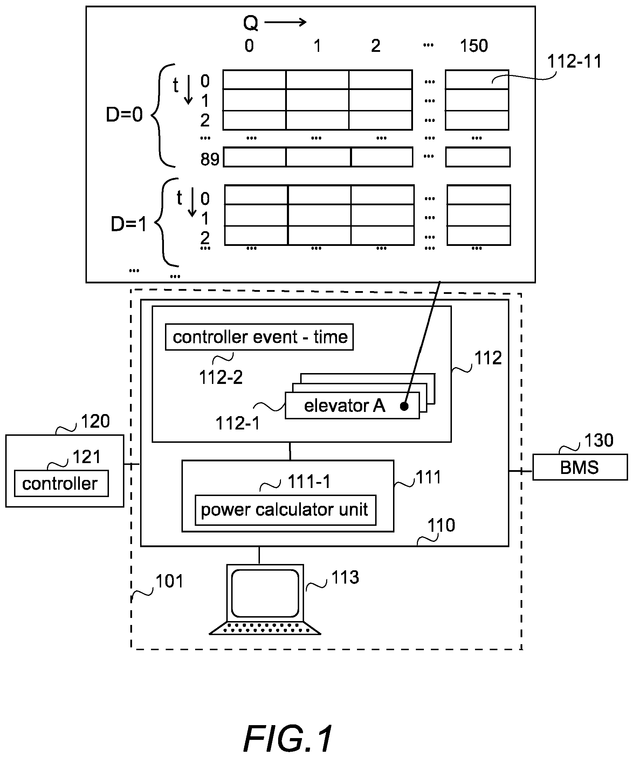

Figure 1 illustrates a highly simplified elevator remote monitoring system. The general devices, elements and functions of elevator systems, details of which also depend on the actual type of an elevator system, are known to those skilled in the art, so that a detailed description thereof is omitted herein. Concepts called cloud computing and/or virtualization may be used as well for remote monitoring. The virtualization may allow a single physical computing device to host one or more instances of virtual machines that appear and operate as independent computing devices, so that a single physical computing device can create, maintain, delete, or otherwise manage virtual machines in a dynamic manner. It is also possible that device operations will be distributed among a plurality of servers, nodes, devices or hosts. In cloud computing, network devices (devices belonging to a network), computing devices and/or storage devices provide shared resources. Some other technology advancements, such as Software-Defined Networking (SDN), may cause one or more of the functionalities described below to be migrated to any corresponding abstraction or apparatus or device.

The remote monitoring system 101 may comprise one or more monitoring equipment 110, with different interfaces (not shown separately in Figure 1) towards controllers 121, a controller controlling one or more elevators in buildings 120 and towards other devices/systems, likes building management systems (BMS) 130, and one or more user interfaces providing monitor and manipulation possibilities remotely and/or on the site via user devices 113. The way (network technology used, protocols used etc.) how the monitoring equipment 110 communicates with the controllers 121 and with the other devices 130 bears no significance, any known or future technology/protocol may be used, and hence there is no need to describe it in more detail herein.

The monitoring equipment 110 comprises one or more devices 111 configured to run one or more applications to monitor and possibly manage elevators, using possibly information in a data storage 112, as is known in the art. To support elevator-specific power consumption estimation, the device 111 comprises a power calculator unit 111-1 and the data storage 112 stores one or more elevator-specific static power consumption models 112-1. There may be one model per elevator or there may be models per elevator, for example a model per a speed or speed range the elevator can move, and/or a model per a different acceleration of the elevator, just to list some non-limiting examples. Further, in case the elevator comprises several cars, and/or there is a group of elevators the same model for cars in one elevator and different models for different elevators in the group may be used. It should be appreciated that the power calculator unit 111-1, or part of its functionality described below, with corresponding elevator-specific one or more static power consumption models, may be integrated to a device comprising the elevator controller 121 and/or to the building management system 130.

The data storage 112 may store also other information, for example events 112-2 (controller events) received from a controller 121 with corresponding time information. The time information may be a time stamp. Naturally, the data storage 112 may store other information, not illustrated herein. The data storage 112 may be any kind of conventional or future data repository, including distributed and centralized storing of data, managed by any suitable management system forming part of the device management. An example of distributed storing includes a cloud-based storage in a cloud environment (which may be a public cloud, a community cloud, a private cloud, or a hybrid cloud, for example). Cloud storage services may be accessed through a co-located cloud computer service, a web service application programming interface (API) or by applications that utilize API, such as cloud desktop storage, a cloud storage gateway or Web-based content management systems. However, the implementation of the data storage, the manner how data is stored, retrieved and updated, and the location where the data are stored are irrelevant to the invention.

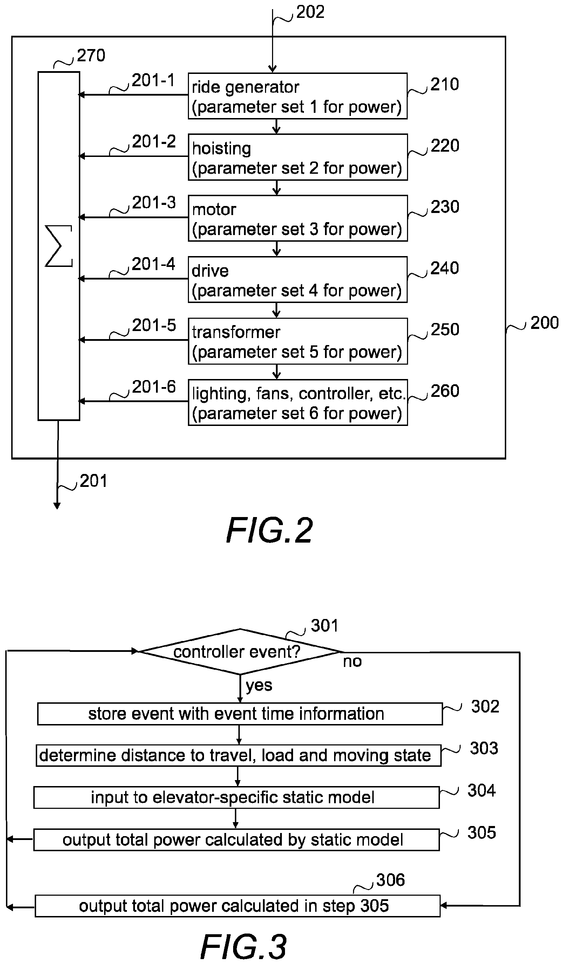

A static power consumption model 112-1 may be a power profile comprising pre-calculated values, an example without values being shown in Figure 1, or a power model for calculating in real-time power consumption values, an example being shown in Figure 2.

The power profile 112-1 illustrated in Figure 1 is a 3-dimensional matrix, the dimensions being a distance to travel (D), load (Q) and time (t). A pre-calculated power consumption value 112-11 can be obtained (retrieved) using index values for the dimensions. In the illustrated example, each distance to travel, in number of floors, has 151 load-specific power sub-profiles which are 90 seconds long. In other words, in the illustrated example there is a sub-profile for each load percentage of a rated load. The same time index values and load index values can be used for various elevators, but the distance to travel index values depend on the building and the location of the elevator in the building. However, the number of load -specific power sub-profiles and/or their length. i.e. the load index values and time index values, may vary from power-profile 112-1 to power profile, and even within a power-profile between different distance to travel indexes.

The different values in the power profile have been pre-calculated using a static power consumption model, which has been parameterized using elevator-specific parameters. However, there is no need to use precalculated values but the elevator-specific static power consumption model may be used to obtain power consumption values. Figure 2 illustrates an example of a static power consumption model.

Referring to Figure 2, a static power consumption model 200 of an elevator may be composed of different power consumption units (parts), based on different power consuming parts (devices) of the elevator. A power consumption unit has a set of unit-specific static parameters and contributes to the total power consumption 270 of the elevator. In the illustrated example, the power consumption model 200 comprises a ride generator unit 210 with parameter set 1 for power consumption calculations, a hoisting unit 220 with parameter set 2 for power consumption calculations, a motor unit 230 with parameter set 3 for power consumption calculations, a drive unit 240 with parameter set 4 for power consumption calculations, a transformer unit 250 with parameter set 5 for power consumption calculations, and a unit 260 for other power consuming parts, such as lighting, fans, controller, elevator doors, etc. with parameter set 6 for power consumption calculations. It should be appreciated that any other division to units may be used, including no division.

The granularity of the parametrization using static parameters depends on available data and accuracy requirements. A non-limiting list of examples of static parameters usable in the parametrization include speed, acceleration, jerk, travel distance between floors, maximum travel distance, nominal load, roping, rope type, cable type, motor resistance, motor type (model), drive efficiency, drive type (model) etc. It should be appreciated that the amount of parameters used in the parametrization may be quite big. For a manufacturer of the elevator, the parameters are easily available, thanks to the data obtained during manufacturing process, whereas parametrizing an elevator manufactured by someone else may require on-site measurements. Nevertheless, it is possible to define parameterized static power consumption models also for elevators that have been in use many years.

Once the parametrization of the static power consumption model has been ended, the static power consumption model can be used in real-time to calculate the total power consumption, or to pre-calculate the values for the elevator-specific power profile by simulating different control events. In both cases the input 202 to the model is based on a controller event. The controller event may indicate a start floor, a stop floor, a load weighing measurement result, and/or a moving state. The moving state indicates an operating mode, example of which include accelerating, nominal speed, decelerating, releveling, and standing, the operating mode also indicating a door state, which may be opening doors, doors open, closing doors and doors closed. For escalators or moving walkways the control event may be escalator/walkway speed and passenger count. The inputted control event 202 passes through the units, each unit outputting 201-1, 201-2, 201-3, 201-4, 201-5, 201-6 its power consumption (which may be zero), the sum of which is then outputted as a total power consumption.

Figure 3 is a flow chart illustrating an example functionality of the power calculator unit when the model illustrated in Figure 2 is used.

Referring to Figure 3, when a controller event of an elevator is received (step 301: yes), the received controller event with event time information indicating when the event happened is stored in step 302 temporarily. The stored information may be used to synchronize the outputted total power consumption with a real-time clock, for example.

A distance to travel, which may be called a trip, a load and a moving state is determined in step 303 based on the received controller event. For example, the distance to travel may be calculated based on a start floor and a stop floor, and if none is present, the distance to travel is zero. The load in the controller event may be used as such, or the load may be divided by the rated load to obtain percentage of the rated load and if there is no load, the previous load value of the elevator is used. The moving state is determined based on the operating mode in the controller event and if there is no change in the operating mode, the previous moving state of the elevator is used.

The determined distance to travel, load and moving state are then inputted in step 304 to a static power consumption model which is specific for the elevator, and the total power calculated by the static power consumption model is outputted in step 305, for example to be displayed on a screen and/or to be used as an input to the building management system. Then the process continues to step 301 monitor, whether a controller event of the elevator is received. If not (step 301: no), the same total power as in step 305 is outputted in step 306, and the process continues to step 301 to monitor, whether a controller event of the elevator is received. Hence, the outputted total power is a time series vector.

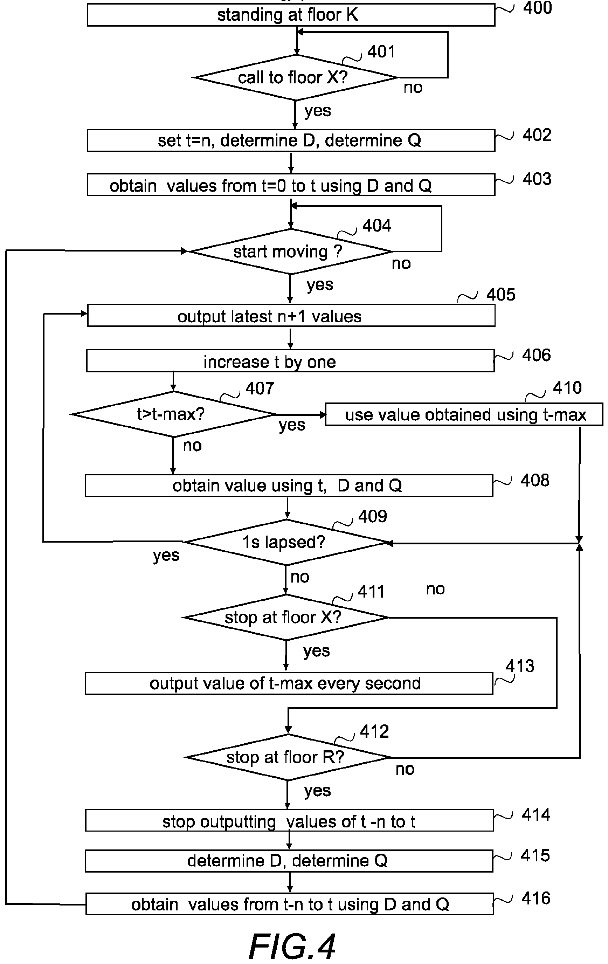

Figure 4 is a flow chart illustrating an example functionality of the power calculator unit when the model illustrated in Figure 1 is used with an elevator having one car. In the illustrated example only few control events are used, for the sake of clarity of explaining, and it is assumed that the car is standing at a floor denoted by K, and that after the car is moving towards a floor X, it may stop at floor R which is between floors K and X, if such a call is received and accepted by the controller. Further, in the illustrated example the elevator-specific static power consumption model is based on an average floor height for that specific elevator, and uses as the distance to travel the number of floors to travel. It should be appreciated that if there are uneven floor-to-floor heights and it is considered that use of the average height does not provide accurate enough predications, a set of static power consumption models taking into account the different floor-to-floor heights could be created and read based on values of FloorStop and FloorStart.

Referring to Figure 4, the elevator (i.e. the car in the elevator) stands (in step 400) at a floor K, until a controller event indicating a call to a floor X is received (step 401: yes). In response to the controller event "call to the floor X", time index t for the 3-D matrix is set in step 402 to be n, wherein n indicates a length of a prediction time. The value of n may be received as a user input or a preset value may be used. For example n could be 30 indicating that the prediction time is 30 seconds. If no prediction are outputted n is zero. Further, a distance to travel index D and a car load Q is determined in step 402.

The distance to travel index value D may be determined using the following algorithm:

```
D = FloorStop - FloorStart
If D < 0:
  D = |D| - 1
Else:
  D = D + Number of floors - 2
```

wherein

FloorStop is in the example of Figure 4 the floor X
FloorStart is in the example of Figure 4 the floor K

For example, with a 16-floor building and with the above algorithm downward travels are in D index values 0....14, and upwards travels are in D index values 15 ...29

The car load Q may be determined using the following formula:

$$Q=Q_{current}-Q_{min-load}$$

or

$$Q = 0, \text{ if } Q_{current}-Q_{min-load}<0$$

wherein

$Q_{current}$ = current car load reading
$Q_{min-load}$ = calculated observed minimum value of the car load

By removing the calculated observed minimum value of the car load the fact that a large portion of the travels of the car occur with an empty, or near empty car, can be taken into account. Further, by using the calculated observed minimum value instead of the absolute minimum value, effect of anomalies and outliers is limited. The observed minimum value of the car may be calculated periodically, for example once a day, once a week, etc, or it may calculated each time the car load value Q is needed. The value may be calculated in numerous ways. For example, it may be a value at the threshold of the smallest percentile (1%) of past current car load readings of the last week/working days in the last week. In another example, a median value of 21 smallest past current car load readings of the last week/working days in the last week, could be used. It should be appreciated that the above are mere examples, and different ways can be used. Further, if there is not enough past car load readings to calculate the observed minimum value reliable, the previous value may used, and zero could be used as the initial value.

Number of floors indicates between how many floors the elevator may travel. Usually, but not necessarily, it is the same as the number of floors in the part of the building the elevator is. The number of floors may be a hardcoded parameter, or calculated from the number of time rows in the power profile. For example, the size of the power profile illustrated in Figure 1 is [2 x (Number of floors -1) x 90, 151], wherefrom the Number of floors can be obtained by dividing the total number of time index rows in the power profile by 180 and adding to the result 1. Still a further possibility is to observe a maximum value of actual position and use average height of floors.

When the index values/value ranges to time t, distance to travel D, and load Q have been determined, values are obtained (retrieved) in step 403 from the power profile. In other words, using the distance to travel and the load, values with time indexes from zero to t value set in step 402 are obtained in step 403.

When a controller event indicating that the elevator started moving (step 404: yes) is received, latest n+1 values are outputted in step 405, and the value of t is increased by one in step 406. The it is checked in step 407, whether the value of t is bigger than the maximum value of index t (t-max) in the power profile. If not (step 407: no), then a next power consumption value is obtained in step 48 from the power profile using the value of t, and the distance to travel D and the load Q, the latter two being defined in step 402. Then it is checked in step 409 whether one second has lapsed after step 405 was performed. This is just to ensure that if the power consumption is outputted second by second, the outputting follows the time. Naturally the check can be adjusted according to the intended output rate, for example 30 seconds by 30 seconds, or minute by minute.

When the one second has lapsed (step 409: yes), the process outputs in step 504 the latest n+1 power consumption values (meaning that the oldest one is not any more outputted but the one obtained in step 408, or determined in step 410 is outputted).

If the value of t is bigger than the maximum value of index t (t-max) in the power profile (step 407: yes), then the power consumption value obtained using the maximum value of index t is used in step 410 as a next power consumption value and the process proceeds to step 409 to check whether the one second has lapsed.

In the meantime, while monitoring whether the one second has lapsed, it is also monitored in step 411 whether a controller event indicating that the elevator stops at floor X is received, or in step 412 whether a controller event indicating that the elevator stops at floor R is received.

If the control event indicates that the elevator has stopped at floor X (step 411: yes), the power consumption value obtained using the maximum value of index t (t-max) is outputted in step 413 every second (and the elevator is standing at floor X so the process is again at step 400, even though the floor is different). In another implementation, the process described in steps 405 to 410 is repeated. In other words, in the implementation the outputted power values are updated as if the car is moving. In a further implementation, for example if the car have energy saving modes for different standby modes, after T seconds from the stop, the outputted power value (newest outputted power value) could be changed to another value.

If the control event indicates that the elevator has stopped at floor R (step 412: yes), outputting values withing time index range t-n to is stopped in step 415, a new distance to travel is determined, using floor R as the start floor, in step 415 and a new load may be determined in step 415. Then values are obtained (retrieved) in step 416 using time range t-n to t, the newly calculated distance to travel, and the newly calculated load Q. In this example, it is assumed, for the sake of clarity that t is still below the maximum value of the index t. If not, then value obtained using the maximum value of the index t is used for all values having t above the maximum value of the index t. Then the process returns to step 404 to when a controller event indicating that the elevator started moving (step 404: yes) is received, and the latest n+1 values are outputted in step 405, the latest n+1 values comprising the last outputted value in step 415.

Implementing the above example to other control events is a straightforward for a person skilled in the art.

It should be appreciated that the value of load Q may be kept as a constant during the car travel, determined in the beginning, since the model takes into account the effect of the shifting net mass, which is affected by the compensation rope, for example. Further, advancing the time variable t as described above, takes care of the syncing of the power demand versus the movement of the car, and hence there is no need to monitor control events indicating the position of the elevator in the shaft. In case the elevator comprises several cars, and/or there is a group of elevators, the outputted power consumption values are a sum of the several cars and/or the group.

As can be seen from the above examples, accurate enough estimations of actual power consumption are obtained using the elevator-specific static power consumption models, without installing separate power meters to different part of the elevator. The outputted power consumption values may be integrated over time to obtain energy consumption (as power P is time derivate of energy E, i.e. $P = \mathrm{d}E/\mathrm{d}t$).

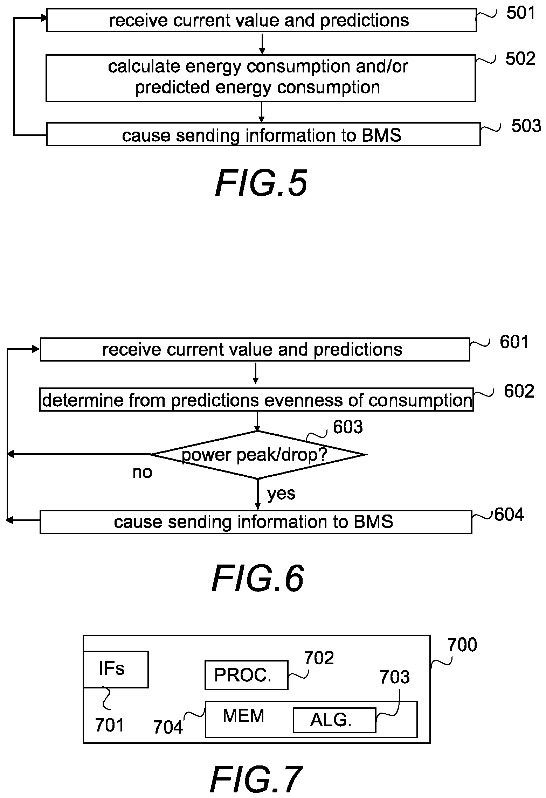

A further advantage, compared to installed power meters measuring current power consumption, is that it is possible to obtain predictions of the power consumption with the static power consumption model. Figures 5 and 6 illustrate examples how the outputted predictions can be used. The functionality may be performed by the power calculator unit, or by another unit receiving outputs from the power calculator unit.

Referring to Figure 5, a power consumption value for the current time and predictions of the power consumption value are received in step 501, and one or both of them are used in step 501 to calculate energy consumption of the apparatus by integrating the total power over a time the energy consumption is to be determined, using also past values, and/or to calculate predicted energy consumption of the apparatus by integrating the predictions of the total power over a time for which the predictions are available. Naturally any other time interval may be used as well. For example the time interval may contain a certain number of past power consumption values and a certain number of predicted power consumption values (not necessarily all available). Then sending the calculated information, or part of it, to the building management system (BMS) is caused in step 503, and the steps are repeated. Hence, the building management system have all information for managing energy consumption, for example. The information sent in step 503 may comprise the energy consumption and/or the predicted energy consumption. Further, the information sent in step 503 may comprise the total power and/or the predictions.

Referring to Figure 6, a power consumption value for the current time and predictions of the power consumption value are received in step 601, and the evenness of the power consumption is determined in step 602 from the predictions. If the evenness does not indicate a power consumption peak or a drop in the power consumption (step 603: no), the process continues to step 601 to receive the power consumption values.

If the evenness indicates a power consumption peak or a drop in the power consumption (step 603: yes), sending information on the peak or on the drop to the building management system (BMS) is caused in step 604, where after the process continues to step 602 to receive the power consumption values.

The building management system can utilise the information on the peak or on the drop to control other power consumptions loads in the building in order to mitigate the effect of the power peaks or utilise the drops. Short peaks in the power demand of an elevator (elevator system) may be dozens of times as high as the average demand, and to mitigate these peaks the building automation system needs information in advance.

The steps, messages and related functions described above in Figures 2 to 6 are in no absolute chronological order, and some of the steps may be performed simultaneously or in an order differing from the given one. Other functions can also be executed between the steps/points or within the steps/points. Some of the steps/points or part of the steps/points can also be left out or replaced by a corresponding step or part of the step within the scope of the appended claims.

The techniques described herein may be implemented within the scope of the appended claims by various means so that an apparatus/equipment implementing one or more functions/operations described above with an embodiment/example, for example by means of any of Figures 1 to 6 and any combination thereof, comprises not only prior art means, but also means for implementing the one or more functions/operations of a corresponding functionality described with an embodiment, for example by means of any of Figures 1 to 6 and any combination thereof, and it may comprise separate means for each separate function/operation, or means may be configured to perform two or more functions/operations. For example, one or more of the means and/or a power calculator unit, or any corresponding unit, for one or more functions/operations described above may be software and/or software-hardware and/or hardware and/or firmware components (recorded indelibly on a medium such as read-only-memory or embodied in hard-wired computer circuitry) or combinations thereof. Software codes may be stored in any suitable, processor/computer-readable data storage medium(s) or memory unit(s) or article(s) of manufacture and executed by one or more processors/computers, hardware (one or more apparatuses), firmware (one or more apparatuses), software (one or more modules), or combinations thereof. For a firmware or software, implementation can be through modules (e.g., procedures, functions, and so on) that perform the functions described herein.

Figure 7 is a simplified block diagram illustrating some units for an apparatus (device, equipment) 700 comprising the power calculator unit, or any corresponding unit or sub-units, or configured otherwise to perform at least some functionality described above, for example by means of any of Figures 1 to 6 and any combination thereof, or some of the functionalities if functionalities are distributed in the future. In the illustrated example, the apparatus 700 comprises one or more interface (IF) entities 701, such as one or more user interfaces, one or more processing entities 702 connected to various interface entities 701 and to one or more memories 704.

The one or more interface entities 701 are entities for receiving and transmitting information, such as communication interfaces comprising hardware and/or software for realizing communication connectivity according to one or more communication protocols, or for realizing data storing and fetching, or for providing user interaction via one or more user interfaces. The one or more user interfaces may be any kind of a user interface, for example a screen, a keypad, or an integrated display device or external display device.

A processing entity 702 is capable to perform calculations and configured to implement at least the power calculator unit, or any corresponding unit or sub-units, described herein, or at least part of functionalities/operations described above, for example by means of any of Figures 1 to 6 and any combination thereof, with corresponding algorithms 703 stored in the memory 704. The entity 702 may include one or more processors, controllers, control units, micro-controllers, etc. configurable to carry out embodiments/examples/implementations or operations described above, for example by means of any of Figures 1 to 6 and any combination thereof. Generally a processor is a central processing unit, but the processor may be an additional operation processor or a multicore processor or a microprocessor.

A memory 704 is usable for storing a computer program code required for the power calculator unit, or any corresponding unit or sub-units, or for one or more functionalities/operations described above, for example by means of any of Figures 1 to 6 and any combination thereof, i.e. the algorithms for implementing the functionality/operations described above by means of any of Figures 1 to 6 and any combination thereof. The memory 704 may also be usable for storing, at least temporarily other possible information, like the received controller events with corresponding time information, or one or more elevator-specific power consumption models.

As a summary, the power calculator unit or corresponding sub-units and/or algorithms for functions/operations described herein, for example by means of means of any of Figures 1 to 6 and any combination thereof, may be configured as a computer or a processor, or a microprocessor, such as a single-chip computer element, or as a chipset, or one or more logic gates including at least a memory for providing storage area used for arithmetic operation and an operation processor for executing the arithmetic operation. Each or some or one of the units/sub-units and/or algorithms for functions/operations described above, for example by means of means of any of Figures 1 to 6 and any combination thereof, may comprise one or more computer processors, application-specific integrated circuits (ASIC), digital signal processors (DSP), digital signal processing devices (DSPD), programmable logic devices (PLD), field-programmable gate arrays (FPGA), graphics processing units (GPU) and/or other hardware components that have been programmed and/or will be programmed by downloading computer program code (one or more algorithms) in such a way to carry out one or more functions of one or more embodiments/examples.

An embodiment provides a computer program embodied on any client-readable distribution/data storage medium or memory unit(s) or article(s) of manufacture, comprising program instructions executable by one or more processors/computers, which instructions, when loaded into an apparatus (device, equipment), constitute the power calculator unit, or any corresponding unit, or an entity providing corresponding functionality, or at least part of the corresponding functionality. Programs, also called program products, including software routines, program snippets constituting "program libraries", applets and macros, can be stored in any medium, including non-transitory computer readable storage medium, and may be downloaded into an apparatus. In other words, each or some or one of the converters/ units and/or the algorithms for one or more functions/operations described above, for example by means of any of Figures 1 to 6 and any combination thereof, may be an element that comprises one or more arithmetic logic units, a number of special registers and control circuits.

Even though the invention has been described above with reference to examples according to the accompanying drawings, it is clear that the invention is not restricted thereto but can be modified in several ways within the scope of the appended claims. Therefore, all words and expressions should be interpreted broadly and they are intended to illustrate, not to restrict, the embodiment. It will be obvious to a person skilled in the art that, as technology advances, the inventive concept can be implemented in various ways within the scope of the claims. Further, it is clear to a person skilled in the art that the described embodiments may, but are not required to, be combined with other embodiments in various ways, within the scope of the appended claims.

**Claims**

1. A remote monitoring equipment (110, 700) for an apparatus, which is an elevator or an escalator or a moving walkway, **characterized by**, the equipment comprising:

   a data storage comprising apparatus-specific static power consumption models (112-1, 200), a static power consumption model modelling power consumption and being parametrized (210, 220, 230, 240, 250, 260) with apparatus-specific parameters;
   means (111, 701) for receiving controller events relating to the apparatus;
   means (111, 702) for determining from the controller events a distance to travel, a time and a load;
   means (111-1, 702) for calculating, using an apparatus-specific static power consumption model of the apparatus and the distance to travel, the time and the load, a total power consumed by the apparatus; and
   means (113, 701) for outputting the total power.

2. A remote monitoring equipment (110, 700) as claimed in claim 1, wherein the means (111-1, 702) for calculating are configured to calculate predictions of the total power and the means for outputting are configured to output the predictions of the total power.

3. A remote monitoring equipment (110, 700) as claimed in claim 1 or 2, wherein the equipment further comprises means (111-1, 702) for calculating energy consumption of the apparatus by integrating the total power over a time the energy consumption is to be determined and/or means (111-1, 702) for calculating a predicted energy consumption of the apparatus by integrating the predictions of the total power over a time for which the predictions are available.

4. A remote monitoring equipment (110, 700) as claimed in any preceding claims, wherein the equipment further comprises means (111, 701) for sending the total power and/or the predictions of the total power and/or the energy consumption and/or the predicted energy consumption to a building management system (130).

5. A remote monitoring equipment (110, 700) as claimed in claim 2, 3 or 4, wherein the equipment further comprises means (111) for detecting a peak or drop in the predictions and means for sending information on the peak or drop to a building management system for mitigating the change in the power consumption.

6. A remote monitoring equipment (110, 700) as claimed in any preceding claim, wherein the equipment further comprises means (111) for storing to the data storage (112) received controller events with time information (112-2).

7. A remote monitoring equipment (110, 700) as claimed in any preceding claim, wherein at least one of the apparatus-specific static power consumption models (112-1, 200) is a precalculated three dimensional matrix, the dimensions being a distance to travel, a load and a time.

8. A remote monitoring equipment (110, 700) as claimed in any preceding claim, wherein the apparatus -specific parameters include one or more of parameters from a group of parameters comprising a speed, an acceleration, a jerk, a travel distance between floors, a maximum travel distance, a nominal load, a roping, a rope type, a cable type, a motor resistance, a motor type, drive efficiency, and a drive type.

9. A remote monitoring equipment (700) as claimed in any preceding claim, the remote monitoring equipment further comprising at least one processor (702); and at least one memory (704) including computer program code (703); the at least one memory and the computer program code being configured to, with the at least one processor, provide the means.

10. A computer implemented method comprising:

    receiving (301) controller events relating to an apparatus, which is an elevator or an escalator or a moving walkway;
    determining (303) from the controller events a distance to travel, a time and a load;
    calculating (304), using an apparatus-specific static power consumption model of the apparatus, which models power consumption and has been parametrized with apparatus-specific parameters, and the distance to travel, the time and the load, a total power consumed by the apparatus; and
    outputting (305) the total power.

11. A computer implemented method as claimed in claim 10, further comprising:

calculating (403, 408, 416), using the apparatus-specific static power consumption model the distance to travel, the time and the load, predictions of the total power; and
outputting (405, 413) the predictions of the total power.

12. A computer implemented method as claimed in 10 or 11, the method further comprising:

calculating (502) energy consumption by integrating the total power over a time the energy consumption is to be determined; and
causing (503) sending the energy consumption to a building management system.

13. A computer implemented method as claimed in 11 or 12, the method further comprising:

calculating (502) a predicted energy consumption of the apparatus by integrating the predictions of the total power over a time for which the predictions are available; and
causing (503) sending the energy consumption to the building management system.

14. A computer implemented method as claimed in 11, 12 or 13, the method further comprising:

detecting (603) a peak or drop in the predictions; and
causing (604) sending information on the peak or drop to a building management system for mitigating the change in the power consumption.

15. A computer implemented method as claimed in claim 10, 11, 12, 13 or 14, further comprising storing (302) received controller events with time information.

16. A computer program product comprising program instructions which, when the program is executed by a computing device, cause the computing device to carry out at least one of the methods as claimed in any of claims 10 to 15.

17. A computer-readable storage medium stored thereon the computer program product of claim 16.

**Patentansprüche**

1. Fernüberwachungsausrüstung (110, 700) für eine Vorrichtung, bei der es sich um einen Aufzug oder eine Fahrtreppe oder einen Fahrsteig handelt, **dadurch gekennzeichnet, dass** die Ausrüstung umfasst:

einen Datenspeicher, der gerätespezifische statische Leistungsverbrauchsmodelle (112-1, 200) umfasst, wobei ein statisches Leistungsverbrauchsmodell den Leistungsverbrauch modelliert und mit gerätespezifischen Parametern parametriert wurde (210, 220, 230, 240, 250, 260);
Mittel (111, 701) zum Empfangen von Steuerungsereignissen, die sich auf die Vorrichtung beziehen;
Mittel (111, 702) zum Bestimmen einer Fahrtstrecke, einer Zeit und einer Last ausgehend von den Steuerungsereignissen;
Mittel (111-1, 702) zum Berechnen einer Gesamtleistungsaufnahme der Vorrichtung unter Verwendung eines gerätespezifischen statischen Leistungsverbrauchsmodells der Vorrichtung und der Fahrtstrecke, der Zeit und der Last; und
Mittel (113, 701) zum Ausgeben der Gesamtleistung.

2. Fernüberwachungsausrüstung (110, 700) nach Anspruch 1, wobei die Mittel (111-1, 702) zum Berechnen dafür konfiguriert sind, Vorhersagen der Gesamtleistung zu berechnen, und die Mittel zum Ausgeben dafür konfiguriert sind, die Vorhersagen der Gesamtleistung auszugeben.

3. Fernüberwachungsausrüstung (110, 700) nach Anspruch 1 oder 2, wobei die Ausrüstung ferner Mittel (111-1, 702) zum Berechnen des Energieverbrauchs der Vorrichtung durch Integrieren der Gesamtleistung über einen Zeitraum, für den der Energieverbrauch zu bestimmen ist, und/oder Mittel (111-1, 702) zum Berechnen eines vorhergesagten Energieverbrauchs der Vorrichtung durch Integrieren der Vorhersagen der Gesamtleistung über einen Zeitraum, für den die Vorhersagen verfügbar sind, umfasst.

4. Fernüberwachungsausrüstung (110, 700) nach einem der vorstehenden Ansprüche, wobei die Ausrüstung ferner Mittel (111, 701) zum Übermitteln der Gesamtleistung und/oder der Vorhersagen der Gesamtleistung und/oder des Energieverbrauchs und/oder des vorhergesagten Energieverbrauchs an ein Gebäudemanagementsystem (130) umfasst.

5. Fernüberwachungsausrüstung (110, 700) nach Anspruch 2, 3 oder 4, wobei die Ausrüstung ferner Mittel (111) zum Erkennen einer Spitze oder eines Abfalls in den Vorhersagen und Mittel zum Senden von Informationen über die Spitze oder den Abfall an ein Gebäudemanagementsystem zur Abschwächung der Änderung des Leistungsverbrauchs umfasst.

6. Fernüberwachungsausrüstung (110, 700) nach einem der vorstehenden Ansprüche, wobei die Ausrüstung ferner Mittel (111) zum Speichern der empfangenen Steuerungsereignisse mit Zeitinformationen (112-2) in dem Datenspeicher (112) umfasst.

7. Fernüberwachungsausrüstung (110, 700) nach einem der vorstehenden Ansprüche, wobei mindestens eines der gerätespezifischen statischen Leistungsverbrauchsmodelle (112-1, 200) eine vorberechnete dreidimensionale Matrix ist, wobei die Dimensionen eine Fahrtstrecke, eine Last und eine Zeit sind.

8. Fernüberwachungsausrüstung (110, 700) nach einem der vorstehenden Ansprüche, wobei die gerätespezifischen Parameter einen oder mehrere Parameter aus einer Gruppe von Parametern bestehend aus Geschwindigkeit, Beschleunigung, Ruck, Fahrtstrecke zwischen Stockwerken, maximaler Fahrtstrecke, Nennlast, Seilaufhängung, Seiltyp, Kabeltyp, Motorwiderstand, Motortyp, Antriebswirkungsgrad und Antriebstyp umfassen.

9. Fernüberwachungsausrüstung (700) nach einem der vorstehenden Ansprüche, wobei die Fernüberwachungsausrüstung ferner mindestens einen Prozessor (702); und mindestens einen Speicher (704) mit Computerprogrammcode (703) umfasst; wobei der mindestens eine Speicher und der Computerprogrammcode so konfiguriert sind, dass sie zusammen mit dem mindestens einen Prozessor die Mittel bereitstellen.

10. Computerimplementiertes Verfahren umfassend:

    Empfangen (301) von Steuerungsereignissen, die sich auf eine Vorrichtung beziehen, bei der es sich um einen Aufzug oder eine Fahrtreppe oder einen Fahrsteig handelt;
    Bestimmen (303) einer Fahrtstrecke, einer Zeit und einer Last ausgehend von den Steuerungsereignissen;
    Berechnen (304) einer Gesamtleistungsaufnahme der Vorrichtung unter Verwendung eines gerätespezifischen statischen Leistungsverbrauchsmodells der Vorrichtung, das den Leistungsverbrauch modelliert und mit gerätespezifischen Parametern parametriert wurde, und der Fahrtstrecke, der Zeit und der Last; und
    Ausgeben (305) der Gesamtleistung.

11. Computerimplementiertes Verfahren nach Anspruch 10, das ferner umfasst:

    Berechnen (403, 408, 416) von Vorhersagen der Gesamtleistung, unter Verwendung des gerätespezifischen statischen Leistungsverbrauchsmodells, der Fahrtstrecke, der Zeit und der Last; und
    Ausgeben (405, 413) der Vorhersagen der Gesamtleistung.

12. Computerimplementiertes Verfahren nach Anspruch 10 oder 11, wobei das Verfahren ferner umfasst:

    Berechnen (502) des Energieverbrauchs durch Integrieren der Gesamtleistung über einen Zeitraum, für den der Energieverbrauch bestimmt werden soll; und
    Veranlassen (503) der Übermittlung des Energieverbrauchs an ein Gebäudemanagementsystem.

13. Computerimplementiertes Verfahren nach Anspruch 11 oder 12, wobei das Verfahren ferner umfasst:

    Berechnen (502) eines vorhergesagten Energieverbrauchs der Vorrichtung durch Integrieren der Vorhersagen der Gesamtleistung über einen Zeitraum, für den die Vorhersagen verfügbar sind; und
    Veranlassen (503) der Übermittlung des Energieverbrauchs an das Gebäudemanagementsystem.

14. Computerimplementiertes Verfahren nach Anspruch 11, 12 oder 13, wobei das Verfahren ferner umfasst:

Erfassen (603) einer Spitze oder eines Abfalls in den Vorhersagen; und
Veranlassen (604) der Übermittlung von Informationen über die Spitze oder den Abfall an ein Gebäudemanagementsystem zum Abschwächen der Änderung des Leistungsverbrauchs.

15. Computerimplementiertes Verfahren nach Anspruch 10, 11, 12, 13 oder 14, das ferner das Speichern (302) der empfangenen Steuerungsereignisse mit Zeitinformationen umfasst.

16. Computerprogrammprodukt, das Programmbefehle umfasst, die bei Ausführung des Programms durch einen Computer bewirken, dass der Computer mindestens eines der Verfahren nach einem der Ansprüche 10 bis 15 durchführt.

17. Computerlesbares Speichermedium, auf dem das Computerprogrammprodukt nach Anspruch 16 gespeichert ist.

**Revendications**

1. Équipement de contrôle à distance (110, 700) pour un appareil, qui est un ascenseur ou un escalier mécanique ou un tapis roulant, **caractérisé par**, l'équipement comprenant :

   un stockage de données comprenant des modèles de consommation d'énergie statique spécifique à un appareil (112-1, 200), un modèle de consommation d'énergie statique modélisant une consommation d'énergie et étant paramétré (210, 220, 230, 240, 250, 260) avec des paramètres spécifiques à un appareil;
   des moyens (111, 701) pour recevoir des événements de contrôleur relatifs à l'appareil;
   des moyens (111, 702) pour déterminer à partir des événements de contrôleur une distance à parcourir, un temps et une charge;
   des moyens (111-1, 702) pour calculer, à l'aide d'un modèle de consommation d'énergie statique spécifique à un appareil de l'appareil et de la distance à parcourir, du temps et de la charge, une énergie totale consommée par l'appareil; et
   des moyens (113, 701) pour sortir l'énergie totale.

2. Équipement de contrôle à distance (110, 700) selon la revendication 1, dans lequel les moyens (111-1, 702) pour calculer sont configurés pour calculer des prévisions de l'énergie totale et les moyens pour sortir sont configurés pour sortir les prévisions de l'énergie totale.

3. Équipement de contrôle à distance (110, 700) selon la revendication 1 ou 2, dans lequel l'équipement comprend en outre des moyens (111-1, 702) pour calculer une consommation d'énergie de l'appareil en intégrant l'énergie totale pendant un temps pour lequel la consommation d'énergie doit être déterminée et/ou des moyens (111-1, 702) pour calculer une consommation d'énergie prévue de l'appareil en intégrant les prévisions de l'énergie totale pendant un temps pour lequel les prévisions sont disponibles.

4. Équipement de contrôle à distance (110, 700) selon l'une quelconque des revendications précédentes, dans lequel l'équipement comprend en outre des moyens (111, 701) pour envoyer l'énergie totale et/ou les prévisions de l'énergie totale et/ou la consommation d'énergie et/ou la consommation d'énergie prévue à un système de gestion de bâtiment (130).

5. Équipement de contrôle à distance (110, 700) selon la revendication 2, 3 ou 4, dans lequel l'équipement comprend en outre des moyens (111) pour détecter un pic ou une baisse dans les prévisions et des moyens pour envoyer une information sur le pic ou la baisse à un système de gestion de bâtiment afin d'atténuer le changement dans la consommation d'énergie.

6. Équipement de contrôle à distance (110, 700) selon l'une quelconque des revendications précédentes, dans lequel l'équipement comprend en outre des moyens (111) pour stocker vers le stockage de données (112) des événements de contrôleur reçus avec une information de temps (112-2).

7. Équipement de contrôle à distance (110, 700) selon l'une quelconque des revendications précédentes, dans lequel au moins l'un des modèles de consommation d'énergie statique spécifique à un appareil (112-1, 200) est une matrice tridimensionnelle pré-calculée, les dimensions étant une distance à parcourir, un temps et une charge.

8. Équipement de contrôle à distance (110, 700) selon l'une quelconque des revendications précédentes, dans lequel les paramètres spécifiques à un appareil incluent un ou plusieurs parmi des paramètres depuis un groupe de paramètres comprenant une vitesse, une accélération, une secousse, une distance à parcourir entre des étages, une distance à parcourir maximale, une charge nominale, un arrangement de cordes, un type de corde, un type de câble, une résistance de moteur, un type de moteur, une efficacité d'entraînement et un type d'entraînement.

9. Équipement de contrôle à distance (700) selon l'une quelconque des revendications précédentes, l'équipement de contrôle à distance comprenant en outre au moins un processeur (702); et au moins une mémoire (704) incluant un code de programme d'ordinateur (703); la au moins une mémoire et le code de programme d'ordinateur étant configurés pour, avec le au moins un processeur, fournir les moyens.

10. Procédé mis en œuvre par ordinateur comprenant :

   la réception (301) d'événements de contrôleur relatifs à un appareil, qui est un ascenseur ou un escalier mécanique ou un tapis roulant;
   la détermination (303) à partir des événements de contrôleur d'une distance à parcourir, d'un temps et d'une charge;
   le calcul (304), à l'aide d'un modèle de consommation d'énergie statique spécifique à un appareil de l'appareil, qui modélise une consommation d'énergie et a été paramétré avec des paramètres spécifiques à un appareil, et la distance à parcourir, le temps et la charge, d'une énergie totale consommée par l'appareil; et
   la sortie (305) de l'énergie totale.

11. Procédé mis en œuvre par ordinateur selon la revendication 10, comprenant en outre :

   le calcul (403, 408, 416), à l'aide du modèle de consommation d'énergie statique spécifique à un appareil de la distance à parcourir, du temps et de la charge, de prévisions de l'énergie totale; et
   la sortie (405, 413) des prévisions de l'énergie totale.

12. Procédé mis en œuvre par ordinateur selon les revendications 10 ou 11, le procédé comprenant en outre :

   le calcul (502) d'une consommation d'énergie en intégrant l'énergie totale pendant un temps pour lequel la consommation d'énergie doit être déterminée; et
   le fait de provoquer (503) l'envoi de la consommation d'énergie à un système de gestion de bâtiment.

13. Procédé mis en œuvre par ordinateur selon les revendications 11 ou 12, le procédé comprenant en outre :

   le calcul (502) d'une consommation d'énergie prévue de l'appareil en intégrant les prévisions de l'énergie totale pendant un temps pour lequel les prévisions sont disponibles; et
   le fait de provoquer (503) l'envoi de la consommation d'énergie au système de gestion de bâtiment.

14. Procédé mis en œuvre par ordinateur selon les revendications 11, 12 ou 13, le procédé comprenant en outre :

   la détection (603) d'un pic ou d'une baisse dans les prévisions; et
   le fait de provoquer (604) l'envoi d'une information sur le pic ou la baisse à un système de gestion de bâtiment pour atténuer le changement dans la consommation d'énergie.

15. Procédé mis en œuvre par ordinateur selon les revendications 10, 11, 12, 13 ou 14, comprenant en outre le stockage (302) d'événements de contrôleur reçus avec une information de temps.

16. Produit de programme informatique comprenant des instructions de programme qui, lorsque le programme est exécuté par un dispositif informatique, amènent le dispositif informatique à réaliser au moins l'un des procédés selon l'une quelconque des revendications 10 à 15.

17. Support de stockage lisible par ordinateur stocké sur celui-ci le produit de programme informatique selon la revendication 16.

*FIG.1*

~202

~270

~201-1 ride generator
(parameter set 1 for power) ~210

~201-2 hoisting
(parameter set 2 for power) ~220

~201-3 motor
(parameter set 3 for power) ~230

~201-4 drive
(parameter set 4 for power) ~240

~201-5 transformer
(parameter set 5 for power) ~250

~201-6 lighting, fans, controller, etc.
(parameter set 6 for power) ~260

Σ

~200

~201

*FIG.2*

~301
controller event?
no

yes

store event with event time information ~302

determine distance to travel, load and moving state ~303

input to elevator-specific static model ~304

output total power calculated by static model ~305

~306
output total power calculated in step 305

*FIG.3*

standing at floor K ～ 400

call to floor X? ～ 401 — no

yes

set t=n, determine D, determine Q ～ 402

obtain values from t=0 to t using D and Q ～ 403

start moving ? ～ 404 — no

yes

output latest n+1 values ～ 405

increase t by one ～ 406

t>t-max? ～ 407 — yes → use value obtained using t-max ～ 410

no

obtain value using t, D and Q ～ 408

1s lapsed? ～ 409

no

stop at floor X? ～ 411 — no

yes

output value of t-max every second ～ 413

stop at floor R? ～ 412 — no

yes

stop outputting values of t -n to t ～ 414

determine D, determine Q ～ 415

obtain values from t-n to t using D and Q ～ 416

*FIG.4*

```
┌─────────────────────────────────────────────┐
│      receive current value and predictions   │〜 501
└─────────────────────────────────────────────┘
                      ↓
┌─────────────────────────────────────────────┐
│      calculate energy consumption and/or     │〜 502
│         predicted energy consumption         │
└─────────────────────────────────────────────┘
                      ↓
┌─────────────────────────────────────────────┐
│        cause sending information to BMS       │〜 503
└─────────────────────────────────────────────┘
```

## FIG.5

```
┌─────────────────────────────────────────────┐
│      receive current value and predictions   │〜 601
└─────────────────────────────────────────────┘
                      ↓
┌─────────────────────────────────────────────┐
│ determine from predictions evenness of consumption │〜 602
└─────────────────────────────────────────────┘
                      ↓        〜 603
              ╱─────────────────╲
    no   ◄───  power peak/drop?   ───
              ╲─────────────────╱
                      ↓ yes
┌─────────────────────────────────────────────┐
│        cause sending information to BMS       │〜604
└─────────────────────────────────────────────┘
```

## FIG.6

```
┌───────────────────────────────────────────────┐ 700
│                                                │〜
│ ┌─────┐        ┌───────┐  702                  │
│ │ IFs │        │ PROC. │〜         703         │
│ └─────┘        └───────┘            〜         │
│    ⌇        ┌───────────────────────┐          │
│            │  MEM    ┌─────────┐     │          │
│ 701   704〜 │         │  ALG.   │〜   │          │
│            └─────────┴─────────┴─────┘          │
└────────────────────────────────────────────────┘
```

## FIG.7

**EP 3 984 939 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013052943 B